(19) **Europäisches Patentamt European Patent Office Office européen des brevets**

(11) **EP 1 462 184 B1**

(12) **FASCICULE DE BREVET EUROPEEN**

(45) Date de publication et mention
de la délivrance du brevet:
**29.02.2012 Bulletin 2012/09**

(51) Int Cl.:
***B08B 3/08*** *(2006.01)*       ***H01L 21/02*** *(2006.01)*
***H01L 21/20*** *(2006.01)*       ***H01L 21/67*** *(2006.01)*
***H01L 21/762*** *(2006.01)*

(21) Numéro de dépôt: **04290796.4**

(22) Date de dépôt: **25.03.2004**

(54) **Traitement superficiel d'une plaquette semiconductrice avant collage**

Oberflächenbehandlung einer Halbleiterscheibe vor dem Kleben

Surface treatment of a semiconductor wafer before glueing

(84) Etats contractants désignés:
**AT BE BG CH CY CZ DE DK EE ES FI FR GB GR
HU IE IT LI LU MC NL PL PT RO SE SI SK TR**

(30) Priorité: **26.03.2003 FR 0303699**

(43) Date de publication de la demande:
**29.09.2004 Bulletin 2004/40**

(73) Titulaire: **S.O.I.TEC Silicon on Insulator
Technologies
38190 Bernin (FR)**

(72) Inventeurs:
  • **Maleville, Christophe
    38660 La Terrasse (FR)**
  • **Maunand Tussot, Corinne
    38240 Meylan (FR)**

(74) Mandataire: **Le Forestier, Eric et al
Cabinet Regimbeau
20, rue de Chazelles
75847 Paris Cedex 17 (FR)**

(56) Documents cités:
  **EP-A- 0 971 396          US-A1- 2002 020 436
  US-A1- 2002 062 841**

  • **FUJIMO S ET AL: "SILICON WAFER DIRECT
    BONDING THROUGH THE AMORPHOUS LAYER"
    JAPANESE JOURNAL OF APPLIED PHYSICS,
    PUBLICATION OFFICE JAPANESE JOURNAL OF
    APPLIED PHYSICS. TOKYO, JP, vol. 34, no. 10B,
    PART 2, 15 octobre 1995 (1995-10-15), pages
    L1322-L1324, XP000702224 ISSN: 0021-4922**

## Description

La présente invention concerne le collage de deux plaquettes comprenant des matériaux semiconducteurs afin de réaliser des structures pour la micro électronique, l'optique ou l'opto électronique.

L'invention concerne plus précisément la préparation des surfaces de collage des deux plaquettes à coller.

Afin de s'assurer une bonne qualité de mise en contact avant collage des deux plaquettes, il est nécessaire de mettre en oeuvre un nettoyage des surfaces à coller.

Le document EP-A1-0971396 montre un procédé de préparation d'une surface d'une première plaquette pour le collage avec une deuxième plaquette selon le préambule de la revendication 1.

Les nettoyages classiques rencontrés dans l'état de la technique comprennent des étapes consistant à plonger des plaquettes à traiter dans des bains de solution de nettoyage successifs.

Pour le nettoyage de surfaces de plaquettes en semiconducteur, il est ainsi connu d'utiliser un traitement RCA qui comprend :

- un premier bain d'une solution de SC1 (acronyme anglo-saxon de « Standard Clean 1 ») ; contenant de l'hydroxyde d'ammonium ($NH_4OH$), du peroxyde d'hydrogène ($H_2O_2$) et de l'eau dé-ionisée.
- un deuxième bain d'une solution de SC2 (acronyme anglo-saxon de « Standard Clean 2 ») ; contenant de l'acide chlorhydrique (HCl) et du peroxyde d'hydrogène ($H_2O_2$) et de l'eau dé-ionisée.

Le premier bain est destiné principalement à retirer les particules isolées en surface de la plaquette et les particules enterrées au voisinage de la surface, et à les empêcher de se redéposer.

La solution de SC2 est destinée principalement à retirer des contaminations métalliques qui ont pu se déposer en surface de la plaquette, en formant notamment des chlorures.

Cependant, le traitement par RCA n'est quelquefois pas suffisant, il n'enlève notamment pas ou peu les contaminants de type organique.

Or ces contaminants organiques peuvent diminuer l'efficacité de l'enlèvement de matière du RCA.

Ils peuvent aussi porter préjudice à un bon collage des plaquettes lorsqu'ils se situent au niveau de l'interface de celles-ci.

C'est notamment le cas lorsqu'une des deux plaquettes à coller a subi une implantation d'espèces atomiques avant collage au voisinage de la surface à coller suivi d'un détachement au niveau de la zone implantée au cours du procédé connu dit "Smart-Cut". Ces hydrocarbures peuvent dans ce cas, en présence de particules, conduire à la formation de cloques superficielles à la plaquette obtenue après détachement et/ou de zones non transférées entre la zone au niveau de laquelle les espèces ont été implantées et la surface de cette plaquette. Ces cloques augmentent et/ou s'accroissent lors d'un traitement thermique, tel un traitement thermique entrepris au cours du collage pour solidifier celui-ci. Ces hydrocarbures, ou ces contaminants organiques de manière plus générale, peuvent créer de tels problèmes de collage que le détachement n'ait pas lieu.

Pour enlever la contamination organique, on plonge usuellement des plaquettes à coller dans un bain de CARO, qui est une solution contenant de l' $H_2SO_4$ et de l'$H_2O_2$, à une température supérieure à 100°C.

Toutefois, ce type de solution a un coût économique élevé et présente des problèmes liés à la sécurité et à l'environnement et à sa mise en oeuvre (dans le cas notamment de plaquettes douze pouces par exemple).

De plus, les nettoyages utilisant la solution CARO nécessitent des étapes intermédiaires entre le bain à solution CARO et le traitement par RCA, comprenant au moins deux bains de rinçage de la plaquette afin de retirer de la surface de la plaquette toute trace de la solution CARO présente en surface, avant son entrée dans la solution SC1.

Afin de résoudre de tels problèmes liés à l'utilisation de cette solution, il a été trouvé de remplacer la solution CARO par une solution ozonée (03).
De même que la solution CARO, cette nouvelle solution ozonée est apte à enlever les hydrocarbures présents en surface de la plaquette par oxydation, mais a un coût économique plus modeste et constitue une solution moins dangereuse pour l'environnement et la sécurité.
En outre, ce traitement comprenant un bain de solution ozonée ne nécessite pas la mise en oeuvre d'étapes intermédiaires de rinçage entre le bain ozoné et le traitement par RCA.

Optionnellement, la solution ozonée peut être assistée d'ondes mégasoniques pour faciliter l'enlèvement des particules.

D'autre part, pour ce qui est du collage entre deux plaquettes, il peut au moins, dans un premier temps, être réalisé par adhésion moléculaire, liée à l'hydrophilie des surfaces à coller.

Cependant, l'hydrophilie après la mise en oeuvre d'un procédé comprenant un traitement par une solution de CARO ou par une solution ozonée, suivi d'un traitement RCA, reste peu différente d'avant la mise en oeuvre du procédé.

La présente invention tend à améliorer cette situation en proposant selon un premier aspect un procédé de préparation d'une surface d'une plaquette comprenant au moins superficiellement une couche en matériau semiconducteur, la plaquette selon la revendication 1 annexée

Des aspects préférés du procédé de préparation d'une surface sont :

- l'étape b) comprend deux opérations successives :

b1) nettoyer la surface de la première plaquette au moyen d'une solution apte à enlever des particules qui y sont isolées en surface et des particules enterrées ;

b2) nettoyer la surface de la première plaquette au moyen d'une solution apte à enlever des contaminants métalliques ;

- la solution utilisée lors de l'étape b1) est de type SC1 ;
- la solution utilisée lors de l'étape b2) est de type SC2.

Selon un deuxième aspect, un procédé de collage de deux plaquettes comprenant un procédé de préparation des surfaces des deux plaquettes selon l'invention est proposé, lequel procédé de collage comprenant après la mise en oeuvre du procédé de préparation de deux surfaces respectives des deux plaquettes une étape de collage des deux plaquettes au niveau des deux surfaces.

Des aspects préférés du procédé de collage sont:

- le collage est au moins en partie réalisé par hydrophilie au niveau de l'interface des deux plaquettes.
- le collage des deux plaquettes est accompagné d'un traitement thermique apte à solidifier le collage.

Selon un troisième aspect, une application d'un procédé selon l'invention destinée à la réalisation d'une structure semi conducteur-sur-isolant est proposée.

D'autres aspects, buts et avantages de l'invention sont décrits dans la suite de ce document en illustration de la figure suivante :

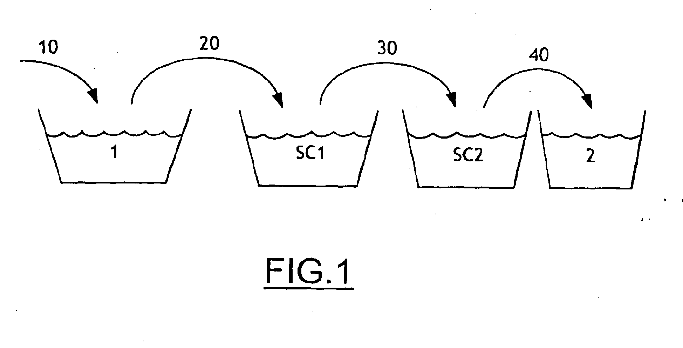

La figure 1 représente les différentes étapes d'un procédé selon l'invention.

Un premier objectif de l'invention concerne un enlèvement de contamination d'hydrocarbures à la surface d'une plaquette à coller.

Un deuxième objectif de l'invention consiste à rendre hydrophile la surface de collage de la plaquette à coller juste avant collage.

Dans la technologie des semiconducteurs, des collages entre deux plaquettes sont quelquefois mis en oeuvre afin de réaliser des structures telles que des structures de type SOI ou transistor ou toute autre structure.

La qualité du collage dépend notamment :

- de la faible rugosité des surfaces à coller ; et/ou
- d'une forte adhésivité entre les plaquettes ;
- du nombre de contaminants (organiques et métalliques) au voisinage des surfaces de collage.

Un traitement selon l'invention pour enlever de la contamination d'hydrocarbures consiste à mettre en contact une plaquette à coller avec une solution ozonée afin de réaliser la réaction chimique suivante :

$$O_3 + \cdot C_xH_y \rightarrow O_2 + CO_2 + H_2O$$

On enlève ainsi les hydrocarbures en les oxydant par l'ozone.

Une solution ozonée peut permettre aussi d'enlever certains contaminants métalliques tel que du cuivre ou de l'argent.

Un bain ozoné facilite aussi l'adhésivité des deux plaquettes à coller lorsque cette adhésivité est réalisée au moins en premier lieu par hydrophilie.

En effet, la présence d'ozone en surface de la plaquette permet d'augmenter l'hydrophilie, c'est-à-dire que lorsqu'on dépose une goutte d'eau sur la surface de la plaquette, elle prend la forme d'une calotte sphérique dont l'angle de raccordement entre la surface de la plaquette et la tangente à la surface du liquide, appelé angle de contact, est moins important que dans un cas identique, sans ozone en surface de la plaquette.

Ainsi, pour une plaquette plongée dans un bain ozoné, l'angle de contact est typiquement compris entre 5 et 15 degrés, ce qui caractérise une surface à caractère hydrophile.

On dit qu'une telle surface à une bonne mouillabilité.

On voit ici le double intérêt de mettre en contact la plaquette à coller avec une solution ozonée.

En référence à la figure 1, est décrit un procédé de traitement de surface d'une plaquette à coller, mettant en oeuvre une succession de traitements chimiques principalement destinés à diminuer la rugosité superficielle de la plaquette ainsi qu'à augmenter l'hydrophilie de celle-ci.

Une première étape du procédé consiste à mettre en contact 10 la plaquette à un fluide (gaz ou liquide) ozoné 1.

Cette première étape est principalement destinée à enlever une majorité de contaminants organiques, tels que des hydrocarbures, en surface de la plaquette afin d'éviter tout défaut de collage, voire toute détérioration structurelle au niveau de l'interface de collage, et pouvant par là même provoquer une détérioration des structures finales à former.

On sait par exemple qu'un collage après implantation d'espèces atomiques réalisée lors, par exemple, de la mise en oeuvre d'un procédé Smart-Cut, connu de l'homme du métier à une profondeur faible sous la surface, peut provoquer de telles détériorations, notamment au cours d'un traitement thermique.

Un autre intérêt de mettre en contact la plaquette avec un bain ozoné tient au fait que les contaminants organiques comprenant des résidus hydrocarbures retarde l'attaque du SC1 du traitement RCA mis en oeuvre lors de la seconde étape, et qu'en enlevant ces contaminants on restitue la vitesse de gravure du SC1, et donc l'efficacité de ce produit (un bon enlèvement de particules étant assuré par une gravure suffisante sous les particules qui sont ainsi « mises en suspension »).

En effet, la Demanderesse a mis en évidence, lors de mesures cartographiques effectuées sur une plaquette ayant subi un traitement SC1 avec une étape préalable de trempage de la plaquette dans un bain ozoné, que les hydrocarbures protégeaient la partie de la plaquette qu'elles couvraient alors que les autres parties de la plaquette (non recouvertes par des contaminants hydrocarbures) étaient traitées sous l'action de la gravure chimique mise en oeuvre par la solution SC1.

Le traitement SC1 ne gravait donc pas la surface de façon uniforme, et donnait alors une rugosité de la surface à coller sensiblement inégale.

En revanche, une plaquette ayant été traitée par une solution SC1 après trempage de la plaquette dans un bain ozoné présentait une rugosité plus uniforme sur la surface.

Mettre en oeuvre une étape de décontamination organique juste avant la mise en oeuvre d'un traitement SC1 améliore donc l'efficacité du traitement SC1.

La Demanderesse a, en outre, comparé une attaque à la surface de la plaquette par une solution comprenant du CARO conforme à l'état de la technique, et la mise en contact de la plaquette avec une solution ozonée.

Des mesures d'épaisseur des couches superficielles avant et après le nettoyage ont montré que l'efficacité d'oxydation des hydrocarbures était sensiblement identique pour les deux types de solution.

En revanche, le traitement de la plaquette avec une solution ozonée ne nécessite pas d'étape de rinçage intermédiaire entre le traitement des contaminants organiques et le traitement RCA, comme c'était le cas pour le traitement au moyen d'une solution CARO.

Une seconde étape du procédé selon l'invention consiste à faire subir à la plaquette un traitement pour enlever des particules isolées en surface et des contaminants métalliques.

Cette seconde étape comprend avantageusement un traitement de type RCA.

Une étape de traitement par RCA comprend deux opérations principales :

- un traitement 20 par une solution de SC1 destiné à enlever les particules isolées en surface de la plaquette et/ou enterrées au voisinage de la surface de celle-ci ; et
- un traitement 30 par une solution SC2 destiné à enlever des contaminations métalliques ayant pu se déposer en surface de la plaquette.

Le traitement par RCA est avantageusement mis en oeuvre en association avec une application d'ondes mégasoniques, ces dernières aidèrent au décollement des particules.

Une troisième étape du procédé selon l'invention comprend la mise en contact 40 de la plaquette avec un second fluide ozoné 2 destiné principalement à augmenter l'hydrophilie en surface de la plaquette afin de pouvoir améliorer l'adhésivité de la plaquette lors de son collage avec une autre plaquette.

En effet, même si la plaquette a subi un premier traitement ozoné 1 au cours de la première étape, elle a perdu au moins en grande partie de l'hydrophilie au cours du traitement RCA.

Cette perte peut générer un mauvais collage, d'où l'intérêt principal de l'action de ce deuxième fluide ozoné 2 afin de rétablir une bonne hydrophilie en le situant dans le temps après les traitements de la seconde étape.

L'hydrophilie est augmentée notamment grâce aux propriétés d'activation de surface associées à la présence d'ozone en surface de la plaquette.

Cette bonne hydrophilie est associée à la formation de la couche d'oxyde par oxydation de la surface de la plaquette par l'ozone.

La mise en contact de la plaquette avec un fluide ozoné est mise en oeuvre selon l'un des deux types de techniques suivantes :

- trempage de la plaquette dans un bain ozoné ; ou
- projection de gouttelettes d'ozone sur le dispositif de collage, simple ou accompagnée d'un rinçage avantageusement à l'eau dé-ionisée, afin de constituer une solution de rinçage ozonée ; ou
- envoi d'un gaz d'ozone.

Après les préparations des surfaces à coller de deux plaquettes, une ou plusieurs étapes de collage des deux plaquettes sont mises en oeuvre.

Le collage consiste avantageusement à une adhésivité hydrophile.

Dans une étape supplémentaire avantageuse, le collage est solidifié par un traitement adapté, tel qu'un traitement thermique.

Dans le cas où la couche d'oxyde formée lors de l'oxydation d'une surface de collage d'au moins une des deux plaquettes ou lors d'une autre étape d'oxydation, cette couche d'oxyde peut améliorer l'adhésivité entre les deux plaquettes de par ses propriétés de collage.

Une étape supplémentaire au collage peut être mise en oeuvre afin de détacher un film d'une des deux plaquettes et le transférer sur l'autre plaquette, afin de réaliser sur l'ensemble comprenant la deuxième plaquette la structure souhaitée.

Dans le cas où l'une des deux surfaces à coller est constituée d'une couche d'oxyde, cette couche d'oxyde peut dans certaines applications de la structure finale constituer une couche isolante électriquement.

C'est notamment le cas d'application à la formation de structures SeOI (acronyme anglo-saxon de "Semiconductor On Insulator"), dont l'épaisseur semiconductrice est constituée du film transféré et la couche isolante est constituée de la couche d'oxyde formée lors de la mise en contact d'une des deux plaquettes avec un fluide ozoné.

Cependant, la présente invention ne se limite pas à une formation de structure de type SeOI, mais concerne 1a formation de tous types de structures comprenant un matériau semiconducteur.

Les plaquettes traitées comprennent des matériaux semiconducteurs tels que le silicium, le germanium, le SiGe, l'AlGaAs, le GaAs, l'InGaAs, l'AlGaAsP, l'InGaAsP, l'InP, ou autres matériaux de type III-V ou II-VI.

**Revendications**

1. Procédé de préparation d'une surface d'une première plaquette pour le collage avec une deuxième plaquette, les deux plaquettes étant destinées à être mises en contact pour réaliser une adhésion entre elles au niveau de la surface à préparer, la surface de la première plaquette comprenant au moins superficiellement une couche en matériau semiconducteur, , **caractérisé en ce qu'**il comprend les étapes suivantes :

   a) oxyder la surface de la première plaquette avec des espèces chimiques ozonées ;
   b) ensuite, nettoyer la surface de la première plaquette au moyen d'espèces chimiques aptes à enlever des particules isolées en surface et des particules enterrées, ainsi que des contaminants métalliques ;
   c) puis, oxyder la surface de la première plaquette avec une solution ozonée.

2. Procédé de préparation d'une surface selon la revendication 1, dans lequel l'étape b) comprend deux opérations successives :

   b1) nettoyer la surface de la première plaquette au moyen d'une solution apte à enlever des particules qui y sont isolées en surface et des particules enterrées ;
   b2) nettoyer la surface de la première plaquette au moyen d'une solution apte à enlever des contaminants métalliques.

3. Procédé de préparation d'une surface selon la revendication dans lequel la solution utilisée lors de l'étape b1) est de type SC1.

4. Procédé de préparation d'une surface selon l'une des revendications 2 et 3, dans lequel la solution utilisée lors de l'étape b2) est de type SC2.

5. Procédé de collage de deux plaquettes comprenant un procédé de préparation des surfaces des deux plaquettes selon l'une des revendications 1 à 4, lequel comprend après la mise en oeuvre du procédé de préparation de deux surfaces respectives des deux plaquettes une étape de collage des deux plaquettes au niveau des deux surfaces.

6. Procédé de collage de deux plaquettes selon la revendications 5, dans lequel le collage est au moins en partie réalisé par hydrophilie, au niveau de l'interface des deux plaquettes.

7. Procédé de collage de deux plaquettes selon l'un des revendications 5 et 6, dans lequel le collage des deux plaquettes est accompagné d'un traitement thermique apte à solidifier le collage.

8. Application d'un procédé selon l'une des revendications 5 à 7 à la réalisation d'une structure semi conducteur-sur-isolant.

**Claims**

1. Process for preparing a surface of a first wafer for bonding with a second wafer, the two wafers being intended to be brought into contact to create adhesion therebetween at the surface to be prepared, the surface of the first wafer comprising at least superficially a layer of semiconductor material, **characterised in that** it comprises the following steps:

   a) oxidising of the surface of the first wafer with ozonized chemical species;
   b) next cleaning of the surface of the first wafer with chemical species capable of removing isolated surface particles and/or buried particles, as well as metallic contaminants;
   c) then oxidising of the surface of the first wafer with an ozonized solution.

2. Process for preparing a surface according to claim 1, wherein step b) comprises two successive operations:

   b1) cleaning of the surface of the first wafer with a solution capable of removing isolated surface particles and/or buried particles;
   b2) cleaning of the surface of the first wafer with a solution capable of removing metallic contaminants.

3. Process for preparing a surface according to claim 2, wherein the solution used during step b1) is of type SC1.

4. Process for preparing a surface according to any of claims 2 and 3, wherein the solution used during step b2) is of type SC2.

5. Process for bonding two wafers comprising a process for preparing the surfaces of the two wafers according to any of claims 1 to 4, comprising, after the application of the process for preparing the two respective surfaces of the two wafers, a step for bonding the two wafers via the two surfaces.

6. Process for bonding two wafers according to claim 5, wherein the bonding is at least partly achieved though the hydrophilicity of the interface of the two wafers.

7. Process for bonding two wafers according to any of claims 5 and 6, wherein the bonding of the two wafers is accompanied by a heat treatment which strengthens the bonding.

8. Application of a process according to any of claims 5 to 7 for producing a Semiconductor-On-Insulator structure.

**Patentansprüche**

1. Verfahren zum Vorbereiten einer Oberfläche einer ersten Platte für das Verkleben mit einer zweiten Platte, wobei die beiden Platten dafür vorgesehen sind, in Kontakt gebracht zu werden, um zwischen ihnen im Bereich der vorzubereitenden Oberfläche eine Adhäsion zu erreichen, wobei die Oberfläche der ersten Platte wenigstens oberflächlich eine Schicht aus einem Halbleitermaterial umfasst, **dadurch gekennzeichnet, dass** es die folgenden Schritte umfasst:

   a) Oxidieren der Oberfläche der ersten Platte mit ozonhaltigen chemischen Substanzen;
   b) anschließend Reinigen der Oberfläche der ersten Platte mit chemischen Substanzen, die dazu geeignet sind, Partikel zu entfernen, die auf der Oberfläche isoliert sind, und Partikel, die eingeschlossen sind, sowie metallische Verunreinigungen;
   c) danach Oxidieren der Oberfläche der ersten Platte mit einer ozonhaltigen Lösung.

2. Verfahren zum Vorbereiten einer Oberfläche nach Anspruch 1, bei dem Schritt b) zwei aufeinanderfolgende Vorgänge umfasst:

   b1) Reinigen der Oberfläche der ersten Platte mittels einer Lösung, die dazu geeignet ist, Partikel zu entfernen, die dort auf der Oberfläche isoliert sind, und Partikel, die eingeschlossen sind;
   b2) Reinigen der Oberfläche der ersten Platte mittels einer Lösung, die dazu geeignet ist, metallische Verunreinigungen zu entfernen.

3. Verfahren zum Vorbereiten einer Oberfläche nach Anspruch 2, bei dem die in Schritt b1) verwendete Lösung vom Typ SC1 ist.

4. Verfahren zum Vorbereiten einer Oberfläche nach einem der Ansprüche 2 und 3, bei dem die in Schritt b2) verwendete Lösung vom Typ SC2 ist.

5. Verfahren zum Verkleben zweier Platten, das ein Verfahren zum Vorbereiten der Oberflächen der beiden Platten nach einem der Ansprüche 1 bis 4 umfasst, wobei es nach der Anwendung des Verfahrens zum Vorbereiten von zwei entsprechenden Oberflächen der beiden Platten einen Schritt zum Verkleben der beiden Platten im Bereich der beiden Oberflächen umfasst.

6. Verfahren zum Verkleben zweier Platten nach Anspruch 5, bei dem das Verkleben wenigstens zum Teil durch Hydrophilie im Bereich der Kontaktfläche der beiden Platten ausgeführt wird.

7. Verfahren zum Verkleben zweier Platten nach einem der Ansprüche 5 und 6, bei dem das Verkleben der beiden Platten von einer Wärmebehandlung begleitet wird, die dazu geeignet ist, die Verklebung zu verfestigen.

8. Verwendung eines Verfahrens nach einem der Ansprüche 5 bis 7 bei der Herstellung einer Struktur vom Typ Halbleiter-auf-Isolator.

## FIG.1

**EP 1 462 184 B1**

## RÉFÉRENCES CITÉES DANS LA DESCRIPTION

**Documents brevets cités dans la description**

- EP 0971396 A1